# EUROPÄISCHE PATENTSCHRIFT

(11) **EP 1 705 029 B1**
(45) Veröffentlichungstag und Bekanntmachung des Hinweises auf die Patenterteilung: **21.07.2010**
(21) Anmeldenummer: 06005793.2
(22) Anmeldetag: 21.03.2006
(51) Int. Cl.: B41N 1/24, B41F 15/34, H05K 3/12

(54) **Sieb für den technischen Siebdruck**
Screen for screen printing
Pochoir pour serigraphie

(30) Priorität: 22.03.2005 DE 202005004664 U; 07.06.2005 DE 202005008936 U
(43) Veröffentlichungstag der Anmeldung: 27.09.2006
(73) Patentinhaber: KOENEN GMBH, 85521 Ottobrunn (DE)
(72) Erfinder: Weber, Ralf, 85521 Ottobrunn/Riemerling (DE); Moser, Karl-Heinz, 85649 Brunnthal (DE)
(74) Vertreter: MERH-IP Matias Erny Reichl Hoffmann

(56) Entgegenhaltungen:
- EP-A- 0 904 938
- US-A- 3 167 004
- US-A- 3 800 697
- US-A- 4 373 441
- US-A- 4 481 881

## Beschreibung

Die Erfindung betrifft ein Sieb für den technischen Siebdruck der im Oberbegriff des Patentanspruchs 1 angegebenen Gattung. Ein derartiges Sieb ist aus der US 4 481 881 bekannt.

Aus der JP-A-59-190 851 sind beispielsweise Siebdrucksiebe für den technischen Siebdruck zur Herstellung von Leiterplatten, Solarelementen od. dgl. bekannt, die zum gezielten Aufbringen einer Lotpaste auf eine Trägerplatte z.B. eine Leiterplatte dienen. Die Siebe bestehen aus einem formsteifen Rechteckrahmen aus Leichtmetall-, Strangguss- oder Edelstahlprofilen, auf dem eine Bespannung aus feinmaschigem Metalldrahtgewebe unter allseitiger Zugspannung festgeklebt ist. In Ausschnitten dieses Stahldrahtgewebes von vorbestimmter Größe sind Schablonen aus dünnem Edelstahlblech befestigt, in das Öffnungen bzw. Pads mit bestimmten Konturen z.B. durch Laserstrahl eingeschnitten oder eingeätzt sind, die das zu druckende Muster darstellen. Die Schablone ist an ihren Rändern mit dem Stahldrahtgewebe fest verbunden, das nach dem Verbindungsvorgang im inneren Bereich der Schablone entfernt wird.

Aus der DE 44 38 281 C ist es bekannt, den Außenrand der Schablone mit dem Siebdrahtgewebe durch einen Rollschweißvorgang zu verschweißen. Die an der Schnittkante des Gewebes freigesetzten Drahtenden können durch eine zweite Schweißnaht an der Schablone festgelegt werden.

Beispielsweise zur Herstellung von Solarzellen kann statt der dünnwandigen Stahlblechschablonen die Siebbespannung aus Metalldrahtgewebe in vorgegebenen Bereichen mit einer photosensiblen Schicht versehen sein. Hierzu wird das Gewebe mit einem photoempfindlichen Material beschichtet und diese Beschichtung wird unter Verwendung eines Diapositivs mit UV-Licht belichtet. Die belichteten Stellen härten aus und die unbelichteten Stellen bleiben wasserlöslich. Das Sieb wird mit Wasser entwickelt, wobei diejenigen Strukturbereiche, durch die die Paste gedrückt wird, geöffnet werden. Die für die unterschiedlichen Druckvorgänge verwendeten Pasten, die mit Hilfe von Rakeln auf die vorbereiteten Siebe aufgebracht werden, haben unterschiedliche Viskositäten. Das Aufbringen dieser pastösen Massen auf die vorbereitete Siebfläche in genau gleichbleibender Schichtdicke kann Probleme bereiten, wenn die Viskosität der jeweiligen Masse relativ hoch ist. Um bei Verwendung einer relativ hochviskosen Paste eine gleichmäßige Verteilung der Lotpaste auf der gesamten Siebfläche zu erhalten, muss der jeweilige Rakelvorgang mit hoher Sorgfalt durchgeführt werden.

Das aus der eingangs zitierten US 4 481 881 bekannte Sieb weist einen formsteifen rechteckigen Rahmen auf, an dem ein feinmaschiges Siebgewebe mit seinem Rand befestigt ist. Das Siebgewebe enthält einen äußeren Streifen aus einem elektrisch nichtleitenden Gewebe, auf dem eine Elektrodenschicht ausgebildet ist. An diesen äußeren rechteckigen Streifen schließt innen ein schmaler weiterer Streifen an, der aus unbeschichtetem Gewebe des äußeren Streifens besteht und eine elektrische Isolierung des zentralen Bereichs darstellt. In diesem zentralen Bereich sind zwei elektrische Anschlussdrähte mit vorgegebenem Zwischenabstand auf dem beschichteten Siebgewebe befestigt. Über am Rahmen fixierte Kabel wird den Anschlüssen Strom zugeführt, um den zentralen Siebbereich durch elektrische Widerstandsheizung zu erwärmen.

In der EP 0 904 938 A1 ist ein Druckverfahren beschrieben, bei welchem auf einer Matrize eine Druckpaste vorgesehen ist, deren Viskosität sich bei Erwärmung vermindert. Die Erwärmung der Matrize erfolgt durch elektrische Induktionsbeheizung, indem ein Strom durch eine beabstandete Spule geführt wird.

Weitere Siebe für den technischen Siebdruck mit elektrischer Beheizung eines zentralen Siebbereiches sind in den US 3 167 004, US 3 800 697 und US 4 373 441 beschrieben. Bei diesen bekannten Sieben erfolgt die Stromzufuhr zur Aufheizung des mittleren Siebgewebebereiches durch elektrische Anschlüsse, die am vorderen und hinteren Querholm des Rahmens angeordnet und befestigt sind.

Aufgabe der Erfindung ist es, ein Sieb für den technischen Siebdruck zu schaffen, das eine gleichmäßige Erwärmung größerer Bereiche und damit eine gleichmäßige Verteilung der Paste über diesen größeren aufzuheizenden Bereich ermöglicht.

Diese Aufgabe wird erfindungsgemäß durch die Merkmale der unabhängigen Ansprüche 1 bzw. 3 gelöst.

Bei dem erfindungsgemäß ausgebildeten Sieb wird durch Einleiten eines Heizstromes mit vorzugsweise einer Spannung von 3 bis 6 V und einer Stromstärke von 20 bis 40 A über die beiden voneinander beabstandeten Winkelleisten der druckaktive Bereich des Siebgewebes bzw. der Metallschablone großflächig auf eine erhöhte Temperatur gebracht und damit auch die aufgetragene Paste erwärmt, was deren Viskosität vermindert. Die gleichmäßige Verteilung der Paste in gleichbleibender Schichtdicke über die gesamte vorgesehene Siebfläche wird dadurch erheblich vereinfacht.

Aufgrund der geringen Drahtdurchmesser im jeweiligen Siebgewebe ist die Herstellung der Verbindungen der elektrischen Anschlüsse direkt auf dem Siebgewebe problematisch, da die Verbindungsmittel eine gute elektrische Leitfähigkeit, eine ausreichende Temperaturfestigkeit und auch eine hohe mechanische Festigkeit haben müssen. Um diese Forderungen zu erfüllen sind die die elektrischen Anschlüsse bildenden Winkelleisten mit ihrem unteren Schenkel großflächig auf dem Siebgewebe bzw. dem Schablonenblech durch Kleben, Löten oder vorzugsweise Rollschweißen befestigt, wobei thermische Überbeanspruchungen der Verbindungselemente vermieden werden. Beim Rollschweißen liegt das Siebgewebe auf einem leitenden Untergrund auf und die Winkelleiste ist mit ihrem unteren einen Fußteil bildenden Schenkel auf den vorgesehenen Gewebeabschnitt aufgelegt. Auf der Oberseite des Schenkels wird eine elektrisch leitende Rolle unter Druck und unter Zuleitung eines elektrischen Stroms bewegt. Der elektrische Stromfluss durch die Rolle bewirkt eine ausreichend hohe Erhitzung und der über die Rolle aufgebrachte Druck führt zu einer formschlüssigen Schweißverbindung der beiden Materialien. Die Stromstärke, die Laufgeschwindigkeit der Rolle und die Andruckkraft können eingestellt werden.

Gemäß der Erfindung sind die elektrischen Anschlussleisten als dünnwandige Winkelleisten oder Winkelschienen ausgebildet und achsparallel zu den Längsholmen des Rahmens mit ihrem Fußteil auf dem Siebgewebe bzw. der Metallschablone seitlich außerhalb des Rakelbereichs angeordnet. Diese Positionierung der elektrischen Winkelschienen führt zu einer gleichmäßigen Stromverteilung im Siebgewebe bzw. in der Metallschablone und damit zu einer gleichmäßigen Erwärmung der ausgewählten Bereiche des Siebgewebes bzw. der Metallschablone, was sich wiederum positiv auf die angestrebt gleichmäßige Verteilung der Druckpaste auswirkt.

Um den Grad der Erwärmung des Siebgewebes bzw. der Metallschablone an die Konsistenz der jeweils verwendeten Paste anzupassen, ist vorteilhaft ein Regler im Heizstromkreis vorgesehen.

Bei einem anderen erfindungsgemäß ausgebildeten Sieb für den technischen Siebdruck, das als druckaktive Elemente keine photosensitive Schicht, sondern eine Metallschablone aus einem Edelstahlblech von etwa 0,1 bis 0,5 mm Dicke aufweist, sind die elektrischen Anschlussleiter zum Erwärmen eines druckaktiven Bereichs der Metallschablone ebenfalls als Winkelleisten ausgebildet, die mit ihrem einen durchgehenden Fußteil bildenden Schenkel großflächig auf dem Schablonenblech befestigt sind und deren aufrechtstehende Schenkel die elektrischen Verbindungselemente für den Anschluss der Stromleitungen tragen. Die Metallschablone wird zumindest in ihrem Druckbereich gleichmäßig auf eine erhöhte Temperatur erwärmt, und zwar vorzugsweise durch elektrische Widerstands- oder Induktions-Heizung. Bei elektrischer Widerstands-Heizung wird durch Einleiten eines Heizstroms von vorzugsweise einer Spannung von 3 bis 6 V und einer Stromstärke von 20 bis 40 A der zwischen den elektrischen Anschlüssen befindliche druckaktive Bereich der Druckschablone großflächig auf eine weitgehend gleichmäßig erhöhte Temperatur gebracht, wodurch die aufgetragene Paste erwärmt und deren Viskosität vermindert wird. Die gleichmäßige Verteilung der Paste in gleichbleibender Schichtdicke über den gesamten Druckbereich der Schablone wird dadurch erheblich vereinfacht. Die Metallschablone kann allseitig in einem formsteifen Rahmen eingespannt und über eine elektrische Isolierung mit dem Rahmen verbunden sein. Daneben kann die Metallschablone auch allseitig von am Rahmen unter Spannung befestigtem feinmaschigem Siebgewebe umgeben sein, wobei das Siebgewebe aus feinen Edelstahldrähten und/oder Kunststofffäden bestehen kann.

In der vorliegenden Beschreibung wird der Ausdruck "Sieb" als übergeordneter Begriff auch für solche Gegenstände verwendet, bei denen die Metallschablone direkt an einer äußeren Halterung, beispielsweise an einem formsteifen Rahmen, unter Spannung dauerhaft oder lösbar befestigt ist und kein eigentliches Siebgewebe vorhanden ist.

Im folgenden werden Ausführungsbeispiele der Erfindung anhand der Zeichnung ausführlich beschrieben. Es zeigen:
- Fig. 1: ein Siebdrucksieb mit feinmaschigem Edelstahlgewebe und photosensitiver Beschichtung in teilgeschnittener perspek- tivischer Ansicht;
- Fig. 2: ein Sieb mit eingespannter Schablone in teilgeschnittener perspektivischer Ansicht;
- Fig. 3: ein weiteres Sieb im Ausschnitt.

Das Sieb weist einen formsteifen Rechteckrahmen auf, dessen Längsholme 1 und Querholme 2, 3 zum Erhalt der erforderlichen Formsteifigkeit aus Aluminiumguss- oder Edelstahlprofilen bestehen. An der Unterseite der Längs- und Querholme ist ein umlaufender Streifen 4 aus einem feinmaschigen Polyestergewebe durch Kleben 5 dauerhaft und großflächig befestigt. Auf einem inneren Randabschnitt dieses umlaufenden Streifens 4 ist der Randabschnitt 7 eines feinmaschigen Edelstahlgewebes 6 mittels einer dauerfesten Klebeverbindung 8 befestigt.

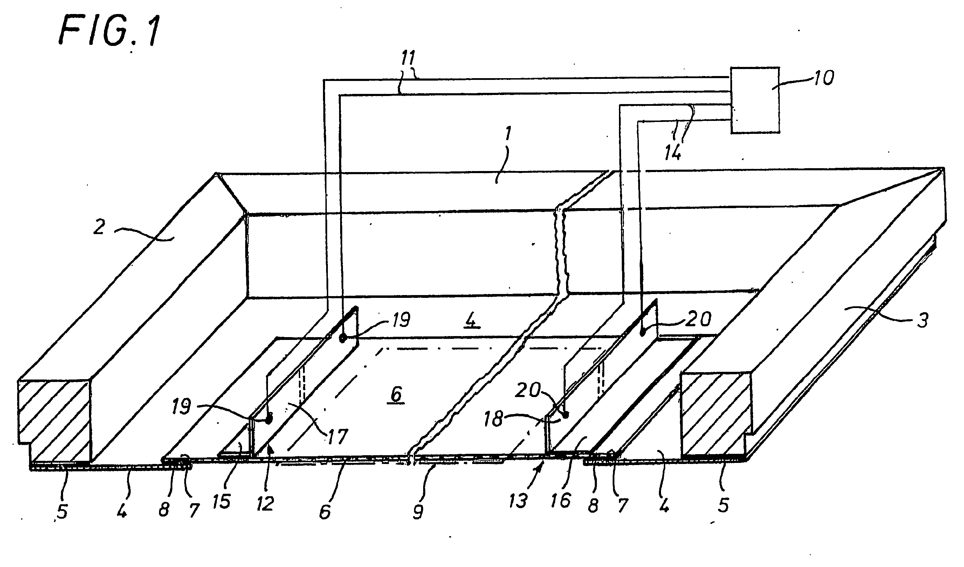

Bei dem in Fig. 1 dargestellten Ausführungsbeispiel ist an der Unterseite des feinmaschigen Edelstahlgewebes 6 eine dünnwandige - hier strichpunktiert angedeutete - photoempfindliche Schicht 9 angeordnet. In dem mittleren Bereich des Edelstahlgewebes 6 kann die für den jeweiligen Siebdruckvorgang ausgewählte pastöse Masse aufgebracht und gleichmäßig verteilt werden. Damit das Auftragen und die Verteilung auch relativ hochviskoser Massen mit gleichbleibender Schichtdicke verbessert wird, ist erfindungsgemäß eine elektrische Beheizung des inneren Bereichs des feinmaschigen Edelstahlgewebes 6 vorgesehen.

Bei den dargestellten Ausführungsbeispielen wird eine elektrische Widerstandsheizung angewendet, die eine schematisch als Block dargestellte Stromquelle 10 mit ggf. integriertem Regler enthält. An diese Stromquelle 10 ist über stromführende Leitungen 11 ein elektrischer Anschluss 12 angeschlossen. Ein weiterer elektrischer Anschluss 13 ist über Leitungen 14 mit Masse bzw. der Stromquelle 10 verbunden. Bei dem dargestellten Ausführungsbeispiel sind die beiden elektrischen Anschlüsse als Winkelleisten 12, 13 ausgebildet, deren einen durchgehenden Fußteil bildender Schenkel 15, 16 großflächig mittels Rollschweißen auf dem Randabschnitt des Edelstahlgewebes 6 befestigt ist. Die aufrecht stehenden Schenkel 17, 18 dieser Winkelleisten 12, 13 tragen die elektrischen Verbindungselemente 19, 20 für den Anschluss der Stromleitungen 11, 14.

Wie dargestellt, können die Winkelleisten durchgehend sein oder - entsprechend den Strichlinien - in mehrere Segmente unterteilt, sein, wobei in diesem Fall jedes Segment ein entsprechendes Verbindungselement 19, 20 aufweist.

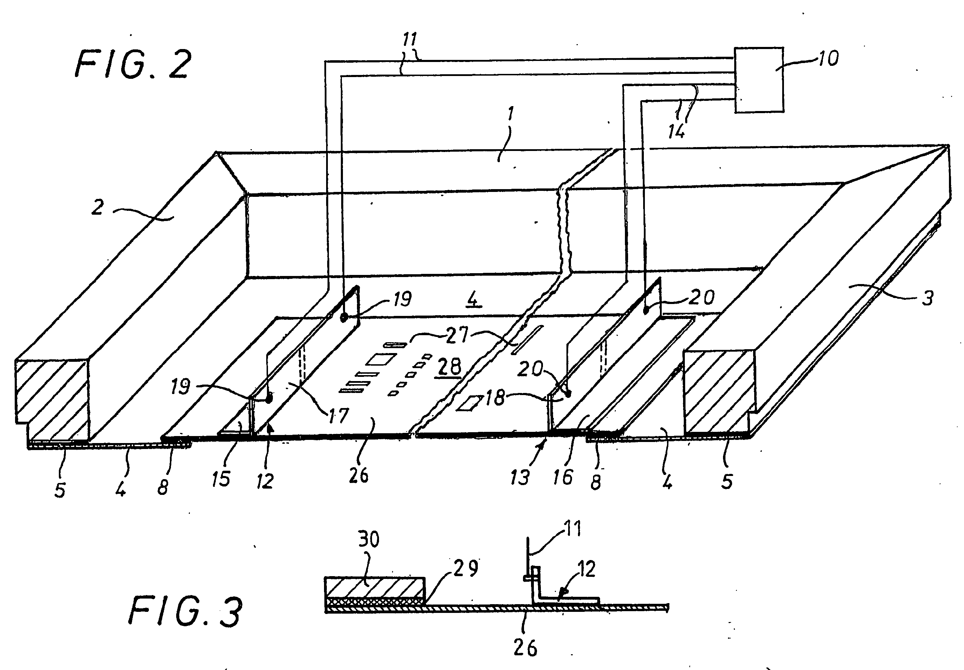

Das in Fig. 2 schematisch dargestellte Sieb weist einen dem Ausführungsbeispiel nach Fig. 1 weitgehend entsprechenden Aufbau auf, so dass die einzelnen Bauteile mit den gleichen Bezugszeichen versehen sind. An den Profilholmen 1, 2, 3 des formsteifen Rahmens ist auch bei dieser Ausführung ein umlaufender Streifen 4 aus einem feinmaschigen Polyestergewebe durch eine Klebeverbindung 5 dauerhaft und großflächig unter Vorspannung befestigt. An dem inneren Randabschnitt dieses umlaufenden Streifens 4 ist eine Metallschablone 26 aus einem dünnen Edelstahlblech von etwa 0,1 bis 0,5 mm Dicke befestigt, und zwar vorteilhaft durch eine dauerfeste Klebeverbindung 8 oder ein anderes geeignetes Verbindungsmittel, das auch unter Spannung die notwendige Dauerfestigkeit besitzt. In dem druckaktiven Bereich 28 der Schablone 26 befinden sich Ausschnitte 27, die vorteilhaft durch Verwendung eines Lasers ausgeschnitten und ggf. fein bearbeitet sein können. Zu beiden Seiten des druckaktiven Bereichs 28 der Schablone 26 sind die auch hier als Winkelleisten ausgeführten elektrischen Anschlüsse 12, 13 vorgesehen, die entweder durch leitende Klebeverbindungen oder Lotverbindungen dauerhaft in vorgegebenen Positionen auf der Metallschablone 26 befestigt sind. Die Ausführung der elektrischen Anschlüsse 12, 13 und ihre Verbindung zur ggf. geregelten Stromquelle 10 entsprechen der in Fig. 1 dargestellten Ausführung.

Die in Fig. 3 schematisch im Ausschnitt dargestellte Variante enthält ebenfalls eine Metallschablone 26 aus dünnwandigem Edelstahlblech mit Ausschnitten (Pads) im druckaktiven Bereich, die jedoch nicht von einem mehr oder weniger breiten Streifen aus einem Siebgewebe umgeben ist, sondern in ihrem umlaufenden Randbereich an einer als Flachrahmen 30 ausgebildeten Spann-Halterung befestigt ist, und zwar vorzugsweise über eine elektrisch und thermisch isolierende Schicht 29. Eine der Ausführung nach Figuren 1, 2 entsprechende Stromzufuhr 12 ist über Leitungen 11 an einer Stromquelle 10 mit ggf. integriertem Regler angeschlossen.

Bei einer weiteren - nicht dargestellten - Variante ist eine Metallschablone 26 in einem Ausschnitt entsprechender Größe eines feinmaschigen Edelstahl-Gewebes z.B. durch Rollschweißen oder andere geeignete Verbindungsmittel befestigt. Der Außenrand dieses Edelstahl-Gewebes kann entweder mit dem Innenrand eines Polyester-Gewebestreifens 4 wie bei dem Ausführungsbeispiel nach Figuren 1, 2 verklebt sein oder das Edelstahl-Siebgewebe ist direkt mit dem äußeren Rahmen 1, 2, 3, 30 über eine elektrische Isolation 29 von geeigneter Ausbildung fest verbunden.

Bei den vorstehend beschriebenen Ausführungsbeispielen sind die elektrischen Anschlüsse 12, 13 jeweils dauerhaft auf dem Siebgewebe (Fig. 1) bzw. der Metallschablone (Figuren 2, 3) befestigt, und zwar jeweils zu beiden Seiten des druckaktiven Bereichs. Durch den Stromfluss wird auf diese Weise eine gleichmäßige Erwärmung des zwischen den Anschlüssen 12, 13 befindlichen druckaktiven Bereichs erzielt. Im Sinne der Erfindung besteht jedoch auch die Möglichkeit, die elektrischen Anschlüsse 12, 13 in geeigneter Ausbildung lösbar und natürlich elektrisch leitend auf dem Siebgewebe bzw. der Metallschablone anzuordnen, um ausgewählte Abschnitte innerhalb des Druckbereichs zu erwärmen und dadurch die Fliessfähigkeit der Paste in besonderen Abschnitten des Druckbereichs, in denen sich beispielsweise eine Vielzahl von filigranen Ausschnitten befinden, zu erhöhen. Als Befestigungsmittel für die elektrischen Anschlüsse können lösbare Steckverbinder, Klemmungen oder andere Elemente verwendet werden. Der Einsatz von lösbaren elektrischen Anschlüssen ermöglicht auch die technisch einfache Nachrüstung bereits bestehender Siebe.

Die Erfindung ist nicht auf die dargestellten Ausführungsbeispiele beschränkt. So können statt der dargestellten Winkelleisten 12, 13 auch andere geeignete Elemente für den Stromanschluss verwendet werden. Schließlich kann statt der angegebenen elektrischen Widerstandsbeheizung auch eine induktive Beheizung der Druckbereiche des Siebgewebes bzw. der Metallschablone Anwendung finden. Um flächenmäßige oder lokale Überhitzungen zu vermeiden und den Heizstrom an die jeweils eingesetzte Ausführung des Edelstahl-Siebgewebes bzw. der Metallschablone anzupassen, kann die Temperatur durch Wärmesensoren überwacht und die Stromzufuhr entsprechend geregelt werden. Ferner können statt der Schablonen aus dünnwandigem Edelstahlblech auch Schablonen aus anderen Materialien, insbesondere aus geeigneten Kunststoffen, eingesetzt werden.

## Patentansprüche

1. Sieb für den technischen Siebdruck mit
- einem formsteifen Rahmen (1, 2, 3),
- einem am Rahmen allseitig unter Spannung befestigten Streifen (4) aus elektrisch nichtleitendem Material,
- einem feinmaschigen Siebgewebe (6) aus elektrisch leitendem Material, vorzugsweise feinen Edelstahldrähten, das allseitig am Innenrand des Streifens (4) unter Spannung befestigt ist,
- dem Siebgewebe (6) zugeordneten druckaktiven Elementen (9) und
- elektrischen Anschlüssen (12, 13), die zur Erwärmung des Siebgewebes (6) in einem druckaktiven Bereich voneinander beabstandet auf dem Siebgewebe (6) befestigt und an eine Stromquelle (10) anschließbar sind,
**dadurch gekennzeichnet, dass**
- die elektrischen Anschlüsse (12, 13) als Winkelleisten ausgebildet sind, die mit ihrem einen durchgehenden Fußteil bildenden Schenkel (15, 16) auf dem Siebgewebe (6) befestigt sind und deren aufrechtstehende Schenkel (17, 18) die elektrischen Verbindungselemente (19, 20) für den Anschluss der Stromleitungen (11, 14) tragen, wobei
- die Winkelleisten (12, 13) achsparallel zu den Längsholmen (2, 3) des Rahmens mit ihrem Fußteil (15, 16) auf dem Siebgewebe (6) seitlich außerhalb des Rakelbereichs angeordnet sind.

2. Sieb nach Anspruch 1,
**dadurch gekennzeichnet, dass**
die Winkelleisten (12, 13) in Einzelsegmente unterteilt sind, von denen jedes ein elektrisches Verbindungselement (19, 20) aufweist.

3. Sieb für den technischen Siebdruck mit
- einem formsteifen Rahmen (1, 2, 3),
- einem am Rahmen allseitig unter Spannung befestigten Streifen (4) aus elektrisch nichtleitendem Material,
- einer Metallschablone (26) aus einem Edelstahlblech von etwa 0,1 bis 0,5 mm Dicke, die am Innenrand des Streifens (4) unter Spannung befestigt ist und in einem druckaktiven Bereich (28) Ausschnitte (27) aufweist, und
- elektrischen Anschlüssen (12, 13), die zur Erwärmung eines druckaktiven Bereichs voneinander beabstandet auf der Metallschablone (26) befestigt und an eine Stromquelle (10) anschließbar sind,
**dadurch gekennzeichnet, dass**
- die elektrischen Anschlüsse (12, 13) als Winkelleisten ausgebildet sind, die mit ihrem einen durchgehenden Fußteil bildenden Schenkel (15, 16) großflächig auf der Metallschablone (26) befestigt sind und deren aufrechtstehende Schenkel (17, 18) die elektrischen Verbindungselemente (19, 20) für den Anschluss der Stromleitungen (11, 14) tragen, wobei
- die Winkelleisten (12, 13) achsparallel zu den Längsholmen (2, 3) des Rahmens mit ihrem Fußteil (15, 16) auf der Metallschablone (26) seitlich außerhalb des Rakelbereichs angeordnet sind.

4. Sieb nach Anspruch 3,
**dadurch gekennzeichnet, dass**
die Metallschablone (26) zumindest in ihrem druckaktiven Bereich (28) durch elektrische Widerstands- oder Induktions-Heizung erwärmbar ist.

5. Sieb nach Anspruch 3 oder 4,
**dadurch gekennzeichnet, dass**
die Metallschablone (26) allseitig an dem formsteifen Rahmen (1, 2, 3; 30) eingespannt und über eine elektrische Isolierung (4; 29) mit dem Rahmen fest verbunden ist.

6. Sieb nach einem der Ansprüche 3 bis 5,
**dadurch gekennzeichnet, dass**
die Metallschablone (26) allseitig von einem am Rahmen unter Spannung befestigten Siebgewebe umgeben ist.

## Claims

1. A screen for the technical screen printing, comprising
- a dimensionally stable frame (1, 2, 3),
- a strip (4) from an electrically non-conductive material attached on all sides with strain to said frame,
- a fine-meshed screen mesh (6) from an electrically conductive material, preferably thin wires from high-grade steel, which is attached on all sides with strain to the inner edge of said strip (4),
- print-active elements (9) associated with said screen mesh (6) and
- electric terminals (12, 13) attached onto said screen mesh (6) in a spaced apart relation and connectable to a current source (10) in order to heat said screen mesh (6) in a print-active region,
**characterized in that**
- said electric terminals (12, 13) are formed as angular ledges which are attached by means of their leg (15, 16) forming a continuous foot portion to said screen mesh (6), while the upright legs (17, 18) thereof support the electric connecting elements (19, 20) serving to couple the current lines (11, 14), wherein
- said angular ledges (12, 13) are arranged with their foot portion (15, 16) on said screen mesh (6) laterally outside of the doctor blade region with parallel axes with respect to the longitudinal spars (2, 3) of said frame.

2. The screen according to claim 1,
**characterized in that**
said angular ledges (12, 13) are divided into individual segments each of which comprises an electric connecting element (19, 20).

3. The screen for the technical screen printing, comprising
- a dimensionally stable frame (1, 2, 3),
- a strip (4) from an electrically non-conductive material attached on all sides with strain to said frame,
- a metallic template (26) from a high-grade steel sheet having a thickness from 0.1 to 0.5 mm attached with strain to the inner edge of said strip (4) and comprising cutouts (27) in a print-active region, and
- electric terminals (12, 13) attached onto said metallic template (26) in a spaced apart relation and connectable to a current source (10) in order to heat a print-active region,
**characterized in that**
- said electric terminals (12, 13) are formed as angular ledges which are attached in a large area by means of their leg (15, 16) forming a continuous foot portion to said metallic template (26), while the upright legs (17, 18) thereof support the electric connecting elements (19, 20) serving to couple the current lines (11, 14), wherein
- said angular ledges (12, 13) are arranged with their foot portion (15, 16) on said metallic template (26) laterally outside of the doctor blade region with parallel axes with respect to the longitudinal spars (2, 3) of said frame.

4. The screen according to claim 3,
**characterized in that**
said metallic template (26) can be heated by an electric resistance or induction heating at least in its print-active region (28).

5. The screen according to claim 3 or 4,
**characterized in that**
said metallic template (26) is clamped on all sides to said dimensionally stable frame (1, 2, 3; 30) and is fixedly connected to said frame via an electric isolation (4; 29).

6. The screen according to one of the claims 3 to 5,
**characterized in that**
said metallic template (26) is surrounded on all sides by a screen mesh attached with strain to said frame.

## Revendications

1. Ecran pour la sérigraphie industrielle avec
- un cadre indéformable (1, 2, 3),
- une bande (4) en un matériau électriquement non conducteur et fixée sous tension de tous côtés sur le cadre,
- un tissu (6) à mailles fines en un matériau électriquement conducteur, de préférence en fins fils d'acier spécial, qui est fixé sous tension de tous côtés sur le bord intérieur de la bande (4),
- des éléments (9) d'impression associés au tissu (6) et
- des connexions électriques (12, 13) qui, pour chauffer le tissu (6), sont fixées espacées les unes des autres sur le tissu (6), dans une zone d'impression, et peuvent être raccordées à une source de courant (10),
**caractérisé en ce que**
- les connexions électriques (12, 13) sont réalisées en tant qu'équerres qui, par leur branche (15, 16) formant un pied continu, sont fixées sur le tissu (6) et dont les branches verticales (17, 18) portent les éléments de liaison (19,20) pour le raccordement des lignes électriques (11, 14),
- les équerres (12, 13) étant disposées parallèlement à l'axe des longerons (2, 3) du cadre, par leur pied (15, 16), sur le tissu (6), sur le côté, à l'extérieur de la zone de la racle.

2. Ecran selon la revendication 1, **caractérisé en ce que** les équerres (12, 13) sont divisées en segments individuels dont chacun comporte un élément de liaison électrique (19, 20).

3. Ecran pour la sérigraphie industrielle avec
- un cadre indéformable (1,2, 3),
- une bande (4) en un matériau électriquement non conducteur et fixée sous tension de tous côtés sur le cadre,
- un pochoir métallique (26) en une tôle d'acier spécial d'environ 0,1 à 0,5 mm d'épaisseur, qui est fixé sous tension sur le bord intérieur de la bande (4) et présente des découpes (27) dans une zone d'impression (28), et
- des connexions électriques qui, pour chauffer le tissu (6), sont fixées espacées les unes des autres sur le tissu (6), dans une zone d'impression, et peuvent être raccordées à une source de courant (10),
**caractérisé en ce que**
- les connexions électriques (12, 13) sont réalisées en tant qu'équerres qui, par leur branche (15, 16) formant un pied continu, sont fixées sur une grande surface sur le pochoir métallique (26) et dont les branches verticales (17, 18) portent les éléments de liaison (19,20) pour le raccordement des lignes électriques (11, 14),
- les équerres (12, 13) étant disposées parallèlement à l'axe des longerons (2, 3) du cadre, par leur pied (15, 16), sur le pochoir métallique (26), sur le côté, à l'extérieur de la zone de la racle.

4. Ecran selon la revendication 3, **caractérisé en ce que** le pochoir métallique (26) peut être chauffé, au moins dans sa zone d'impression (28), par chauffage à résistance électrique ou à induction.

5. Ecran selon l'une quelconque des revendications 3 ou 4, **caractérisé en ce que** le pochoir métallique (26) est serré de tous côtés sur le cadre indéformable (1,2, 3 ; 30) et est relié fixement au cadre par une isolation électrique (4 . 29).

6. Ecran selon l'une quelconque des revendications 3 à 5, **caractérisé en ce que** le pochoir métallique (26) est entouré de tous côtés par un tissu fixé sous tension sur le cadre.
